# EUROPEAN PATENT APPLICATION

(11) **EP 4 386 808 A1**
(43) Date of publication of application: **19.06.2024**
(21) Application number: 22213194.8
(22) Date of filing: 13.12.2022
(51) Int. Cl.: H01J 37/02, H01J 37/15, H01J 37/16

(54) **MODULAR ASSEMBLY**

(71) Applicant: ASML Netherlands B.V., 5500 AH Veldhoven (NL)
(72) Inventor: PEIJSTER, Jerry, Johannes, Martinus, 5500 AH Veldhoven (NL)
(74) Representative: ASML Netherlands B.V.

(57) **Abstract**

The present disclosure relates to modular assembly for engaging modules of an apparatus together. The assembly comprising two modules configured to be mutually engageable to adjoin each other. The modules each having a body 71; 72 and multiple engagers 81; 82 that are each configured to engage with a corresponding engager 82; 81 of another of the modules and to complete a corresponding verification circuit. Each verification circuit is configured to be closed on engagement of an engager of one of the modules with a corresponding engager of the other of the modules. The engager is configured to be electrically isolated from the body of the one of the two modules, and the corresponding engager is configured to be electrically connected to the body of the other of the two modules.

## Description

### FIELD

The present disclosure relates to a modular assembly, a device comprising the modular assembly, and an apparatus comprising the device or the modular assembly.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment for example inspection and/or measurement of a surface of a substrate, or other object/material, is an important process during and/or after its manufacture.

Assessment tools, which herein are referred to as assessment systems, are known that use a charged particle beam to assess objects, which may be referred to as samples, for example to detect pattern defects. These systems typically use electron microscopy techniques, such as a scanning electron microscope (SEM). In a SEM, a primary electron beam of electrons at a relatively high energy is targeted with a final deceleration step to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection system may obtain an image representing characteristics of the material structure of the surface of the sample.

In applications such as charged particle systems (e.g., a SEM) different components, or modules, within the system are desirably aligned correctly with respect to each other during use. In some applications different modules to should be aligned to each other to within a few microns (e.g., 5 microns). Known processes for verifying that modules are accurately aligned require accurate measurement or verification during operation. This can be a challenging and time consuming process, reducing productivity and increasing costs. Furthermore, it can be difficult to verify alignment when the interface, or engaging, surfaces of two adjoining modules is in an obscured or difficult to access region of the apparatus, for example within the apparatus when maintained at vacuum.

### SUMMARY

It is an object of the present disclosure to provide a modular assembly for verifiably engaging modules of an apparatus together.

According to an aspect of the invention, there is provided a modular assembly for engaging modules of an apparatus together, the apparatus for measuring, inspecting, processing or fabricating a semiconductor component. The assembly comprises two modules configured to be mutually engageable to adjoin each other. The modules each have a body and multiple engagers that are each configured to engage with a corresponding engager of another of the modules and to complete a corresponding verification circuit. Each verification circuit is configured to be closed on engagement of an engager of one of the modules with a corresponding engager of the other of the modules. The engager is configured to be electrically isolated from the body of the one of the two modules, and the corresponding engager is configured to be electrically connected to the body of the other of the two modules.

According to another aspect of the invention, there is provided a device for projecting a beam of radiation, such as photons or charged particles, towards a sample. The device comprises the modular assembly.

According to another aspect of the invention, there is provided an apparatus for measuring, inspecting, processing or fabricating a semiconductor component comprising the device or the modular assembly.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1****.**
**FIG. 3** is a schematic diagram of an exemplary electron-optical column comprising a condenser lens array, an objective lens array and a detector array.
**FIG. 4** is a schematic diagram illustrating an exemplary arrangement of a modular assembly comprising three modules each having corresponding engagers.
**FIG. 5** is a schematic diagram illustrating an exemplary arrangement for transmitting data from a detector module to an external data processing apparatus.
**FIG. 6** is a schematic diagram illustrating an exemplary arrangement a module having engagers.
**FIG. 7** is a schematic diagram illustrating an exemplary arrangement a module having corresponding engagers and verification circuits connected to the corresponding engagers.
**FIG. 8A** is a schematic diagram illustrating an exemplary arrangement of engagers, corresponding engagers and verification circuits connected to the corresponding engagers.
**FIG. 8B** is a schematic cross-section diagram through the modules to show operation of the invention when the modules are engaged.
**FIG. 9** is a schematic diagram illustrating a modular assembly comprising the module of **FIG. 7** aligned to the module of **FIG. 8****.**
**FIG. 10A** is a schematic diagram illustrating a plan view of an exemplary arrangement of an engager having a cylindrical shape and a corresponding engager having a cylindrical shape.
**FIG. 10B** is a schematic diagram illustrating a side view of the engager and corresponding engager of **FIG. 10A****.**
**FIG. 11A** is a schematic diagram illustrating a plan view of an exemplary arrangement of an engager having a spherical shape and a corresponding engager having a spherical shape.
**FIG. 11B** is a schematic diagram illustrating a side view of the engager and corresponding engager of **FIG. 11A****.**
**FIG. 12A** is a schematic diagram illustrating a plan view of an exemplary arrangement of an engager having a cylindrical shape and a corresponding engager having a spherical shape.
**FIG. 12B** is a schematic diagram illustrating a side view of the engager and corresponding engager of **FIG. 102A.**
**FIG. 13A** is a schematic diagram illustrating a plan view of an exemplary arrangement of an engager having a planar shape and a corresponding engager having a spherical shape.
**FIG. 13B** is a schematic diagram illustrating a side view of the engager and corresponding engager of **FIG. 13A****.**

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000^{th} of a human hair. Thus, it is not surprising that semiconductor IC manufacturing is a complex and time-consuming process, with hundreds of individual steps. Errors in even one step have the potential to dramatically affect the functioning of the final product. Even a single defect can cause device failure in certain situations. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical device or column. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

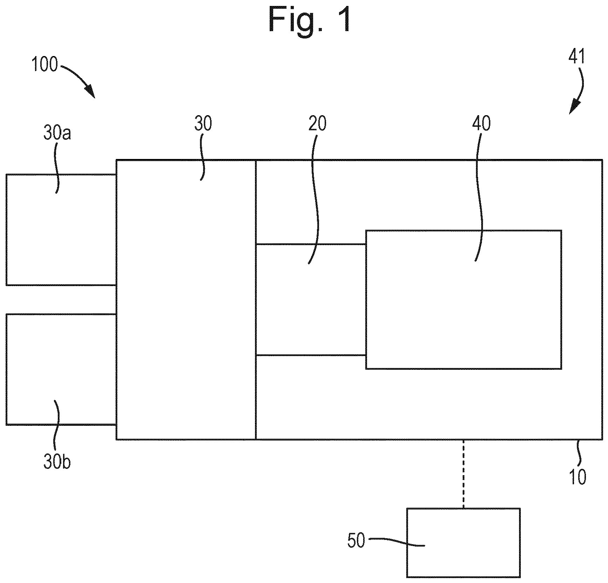

Reference is now made to **FIG. 1****,** which is a schematic diagram illustrating an exemplary charged particle beam inspection apparatus 100, which may also be referred to as a charged particle beam assessment system or simply assessment system. The charged particle beam inspection apparatus 100 of **FIG. 1** includes a main chamber 10, a load lock chamber 20, an electron beam apparatus 40, an equipment front end module (EFEM) 30 and a controller 50. The controller may be distributed between different components of the assessment system, including for example in the electron beam apparatus 40. Electron beam apparatus 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam apparatus by which it may be inspected. An electron beam apparatus 40 may comprise a multi-beam electron-optical apparatus.

Controller 50 is signally, for example electronically, connected to electron beam apparatus 40, for example as distributed components of the controller 50. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection apparatus, it should be noted that aspects of the disclosure in their broadest sense are not limited to a chamber housing an electron beam inspection apparatus. Rather, it is appreciated that the foregoing principles may also be applied to other systems and other arrangements of apparatus, that operate under the second pressure.

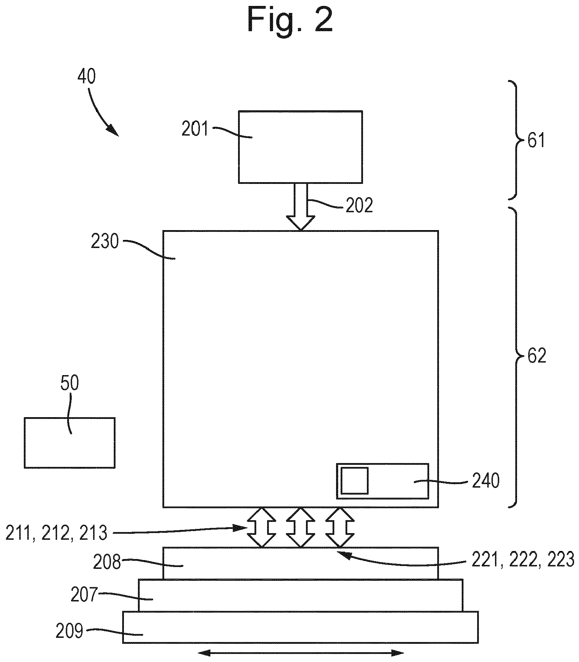

Reference is now made to **FIG. 2**, which is a schematic diagram illustrating an exemplary charged particle beam assessment apparatus 40. The electron beam apparatus 40 may be provided as part of the exemplary charged particle beam inspection system 100 of **FIG. 1****.** The electron beam apparatus 40 comprises an electron source 201 and a charged particle column (or device) 230. The charged particle device 230 may be referred to or comprise a projection apparatus for directing a primary charged particle beam 202 towards a sample 208. The electron source 201 and associated and component charged particle optical elements may be referred to as an illumination apparatus for generating a primary charged particle beam 202. The assessment apparatus comprises a sample support that supports a sample 208. The sample support in this example comprises a sample holder 207. The sample holder 207 holds the sample 208 (e.g., a substrate or a mask) for assessment. The sample holder 207 is supported by a motorized or actuated stage 209. The electron beam apparatus 40 further comprises a detector 240. The detector 240 detects signal charged particles (e.g., electrons) from the sample 208. The detector 240 generates detection signals on detection of the signal charged particles.

The charged particle beam assessment apparatus 40 may comprise a plurality of modules configured to engage each other. For example, as shown in **FIG. 2**, one module 61 may comprise the source 201 and another module 62 may comprise the charged particle device 230. These modules may be configured to engage each other such that the module 61 is aligned with respect to the other module 62. The modules 61, 62 may be configured to align relative to the beam of charged particles 202.

The electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form the primary electron beam 202.

The charged particle device 230 is configured to convert primary electron beam 202 into a plurality of charged particle beams 211, 212, 213 and to direct each beam onto the sample 208. Although three beams are illustrated for simplicity, there may be many tens, many hundreds, many thousands, many tens of thousands, or even hundreds of thousands (or more) of beams. The beams may be referred to as beamlets or sub-beams. The plurality of charged particle beams may be referred to collectively as a multi-beam or beam grid. A beam grid with so many beams (e.g. more than a thousand beams) may have a field of view of e.g. more than 0.5mm, for example in the range of 0.5 to 30mm or 1 to 30 mm.

The controller 50 (for example control system comprising distributed controllers) may be connected to various parts of charged particle beam inspection apparatus 100 of FIG. 1, such as the electron source 201, the electron detection device 240, the charged particle device 230, and actuated stage 209. The controller 50 may perform various image and signal processing functions. The controller 50 may also generate various control signals to govern operations of the charged particle beam inspection apparatus 100, including operations of the electron beam apparatus 40.

The charged particle device 230 may be configured to focus, for example, beams 211, 212, and 213 onto a sample 208 for inspection and may form three probe spots 221, 222, and 223 on the surface of sample 208. The charged particle device 230 may be configured to deflect primary beams 211, 212, and 213 to scan probe spots 221, 222, and 223 across individual scanning areas in a section of the surface of sample 208. In response to incidence of primary beams 211, 212, and 213 on probe spots 221, 222, and 223 on sample 208, electrons are generated from the sample 208 which include secondary electrons and backscattered electrons which may be referred to as signal charged particles. The secondary electrons typically have electron energy as large as fifty electron volts (≤ 50 eV) and backscattered electrons typically have electron energy between fifty electron volts (50 eV) and the landing energy of primary beams 211, 212, and 213.

The detector 240 may send the detection signals generated in the detector 240, for example as an imaging or detection signal, to the controller 50 or a signal processing system (not shown which may be part of the controller 50), e.g. to construct images of the corresponding scanned areas of sample 208. The detector 240 may be incorporated at least partly into the charged particle device 230 or may be separate therefrom, for example where a secondary optical column directs secondary electrons to the detector 240.

The controller 50 may comprise an image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive the detection signal from the detector 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample 208 based on an imaging signal received from the detector 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. A part of the controller for such a function may be comprised in or proximate to the detector. The electron distribution data, collected during a detection time window, can be used in combination with corresponding scan path data of each of primary beams 211, 212, and 213 incident on the sample surface to reconstruct images of the sample structures under inspection. The reconstructed images can be used to reveal various features of the internal or external structures of sample 208. The reconstructed images can thereby be used to reveal any defects that may exist in and/or on, thus of the sample.

The controller 50 may control actuated stage 209 to move sample 208 during inspection of sample 208, for example to provide a scanning motion of the stage relative to the paths of the primary beams. The controller 50 may enable actuated stage 209 to move sample 208 in a direction such as part of the scanning motion of the stage, such as continuously, for example at a constant speed, at least during sample inspection. The controller 50 may control movement of the actuated stage 209 so that it changes the speed of the movement of the sample 208 dependent on various parameters. For example, the controller may control the stage speed (including its direction) depending on the characteristics of the inspection steps and/or scans of the scanning process for example as disclosed in EPA 21171877.0 filed 3 May 2021 which is hereby incorporated by reference in so far as the combined stepping and scanning strategy at least of the stage. In controlling the actuated stage, actuation of the stage and thus the sample may enable the sample to be positioned, for example dynamically, relative to the paths of the primary beams.

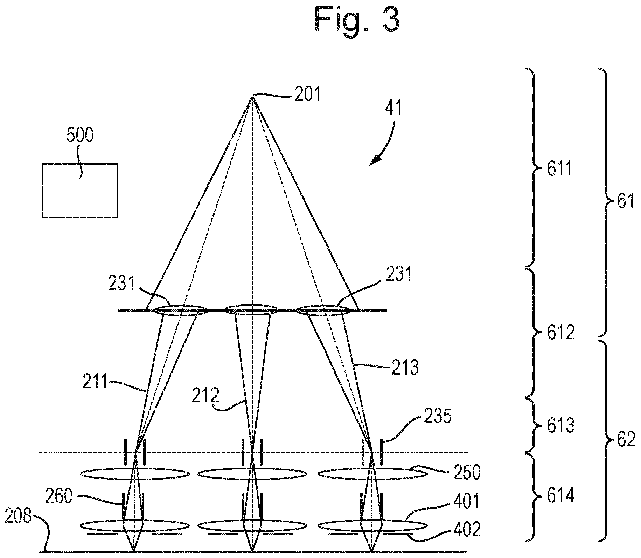

**FIG. 3** is a schematic diagram of an exemplary charged particle device 41 for use in an assessment apparatus. Such a charged particle device 41 may comprise a source 201. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged particle devices such as those discussed herein, it will be understood that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along a path of a beam grid of a plurality of charged particle beams (which may also be referred to as sub-beams). The electrodes are thus also in series along paths of charged particle beams of the beam grid.

Electron source 201 directs electrons toward an array of condenser lenses 231 forming part of charged particle device 230. The electron source 201 is desirably a high brightness thermal field emitter with a good compromise between brightness and total emission current. There may be many tens, many hundreds or many thousands or even tens of thousands of condenser lenses 231. Condenser lenses of array 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array may take the form of at least two, for example three, plates, acting as electrodes, with apertures in each plate aligned with apertures in other plates to define paths for charged particle beams through the plates. At least two of the plates are maintained during operation at different potentials to achieve the desired lensing effect. Between the plates of the condenser lens array are electrically insulating plates, for example made of an insulating material such as ceramic or glass, with one or more apertures for the charged particle beams. Additionally or alternatively, one or more of the plates may feature apertures that each have their own electrode, for example with an array of electrodes around their perimeter or arranged in groups of apertures having a common electrode. In a variant, one or more of the plates may comprise multiple portions or strips with multiple apertures. In a further alternative arrangement, a macro collimator is provided instead of the condenser lens array. The macro collimator may act on the beam from the source 201 before the beam has been split into a multi-beam. The macro collimator may be implemented magnetically, electrostatically, or magnetically and electrostatically.

In some embodiments, the condenser lens array is formed of three plate arrays in which charged particles have the same energy as they enter and leave each lens, which arrangement may take the configuration of an Einzel lens; and may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective beam 211, 212, 213 which is focused at a respective intermediate focus 233. A collimator or an array of collimators may be positioned to operate on the respective intermediate focuses 233. The collimators may take the form of deflectors 235 provided at the intermediate focuses 233. Deflectors 235 are configured to bend a respective beam 211, 212, 213 by an amount effective to ensure that the principal ray (which may also be referred to as the beam axis) is incident on the sample 208 substantially normally (i.e. at substantially 90° to the nominal surface of the sample). Note that in an arrangement with a macro condenser lens, the condenser lens may collimate or contribute to the collimation of the source beam or, in an embodiment, a plurality of beams.

An objective lens array 401 is provided down-beam from the deflectors 235. The objective lens array 501 comprises an objective lens for each beam 211, 212, 213. The objective lens array 401 projects the beams 211, 212, 213 onto the sample 208. The objective lens array 401 may comprise two or more, for example at least three, plate electrode arrays connected to respective potential sources.

Optionally, a control lens array 250 is provided between the deflectors 235 and the objective lens array 401. The control lens array 250 comprises a control lens for each beam 211, 212, 213. The control lens array 250 provides additional degrees of freedom for controlling properties of the beams 211, 212, 213. The control lens array 250 may comprise two or more, for example at least three, plate electrode arrays connected to respective potential sources. A function of control lens array 250 is to optimize the beam opening angle with respect to the demagnification of the beam and/or to control the beam energy delivered to the objective lenses, each of which directs a respective beam 211, 212, 213 onto the sample 208. In an embodiment the control lens array may be considered to be part of the objective lens, for example in being additional plates associated with the objective lens array.

Optionally an array of scan deflectors 260 is provided between the control lens array 250 and the objective lens array 401. The array of scan deflectors 260 comprises a scan deflector for each beam 211, 212, 213. Each scan deflector is configured to deflect a respective beam 211, 212, 213 in one or two directions to scan the beam across the sample 208 in one or two directions. Alternatively, a macro scan deflector may be provided to scan the charged particle beams over the sample 208. The macro scan deflector may be provided up-beam of the control lens array 250. In an embodiment such a macro scan deflector may operate on the source beam and may be present with a macro condenser lens.

A detector module 402 of a detector is provided within the objective lenses or between the objective lenses and the sample 208 to detect signal electrons/particles from the sample 208. An exemplary construction of such a detector module 402 is described below. Note that the detector additionally or alternatively may have detector elements up-beam along the primary beam path of the objective lens array 401 or even the control lens array 250. The detector module may be an array of detector elements (e.g. a detector array). Each element may be associated with an individual beam, for example positioned to detect signal particles generated by the individual beam.

The charged particle device 41 of **FIG. 3** may be configured to control the landing energy of electrons on the sample 208 by varying potentials applied to the electrodes of the control lenses and the objective lenses. The control lenses and objective lenses work together and may be referred to as an objective lens assembly. The landing energy can be selected to increase emission and detection of secondary electrons dependent on the nature of the sample being assessed. The detector module may be comprised in the objective lens assembly.

The objective lenses can be configured to demagnify the electron beam by a factor greater than 10, desirably in the range of 50 to 100 or more. The objective lenses may comprise three electrodes: a middle electrode, a lower electrode and an upper electrode. The upper electrode may be omitted. An objective lens having only two electrodes can have lower aberration than an objective lens having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beams.

In some embodiments, the objective lens array assembly comprises a detector having a detector module 402 down-beam of at least one electrode of the objective lens array 401. The detector module 402 may comprise or even take the form of a detector array. In an embodiment, at least a portion of the detector is adjacent to and/or integrated with the objective lens array 401. For example, the detector module 402 may be implemented by integrating a CMOS chip detector into a bottom electrode of the objective lens array 401. Integration of a detector module 402 into the objective lens array may replace a secondary column. The CMOS chip is preferably orientated to face the sample (because of the small distance between sample and the bottom of the electron-optical system, which may for example be in the range of 10 to 400 micron, desirably in the range of 50 to 200 micron, optionally about 100 micron). It is noted that even in situations in which the detector is up-beam of the most down-beam electron-optical element of the charged particle device, there may be a close, e.g. of similar distance, separation between the most down-beam electron-optical element and the sample (e.g. about 100 micron). In an embodiment, electrodes to capture the signal charged particles are formed in the top metal layer of the CMOS device. The electrodes can be formed in other layers of the substrate, e.g. of the CMOS chip. Power and control signals of the CMOS may be connected to the CMOS by through-silicon vias. For robustness, desirably the bottom electrode consists of two elements: the CMOS chip and a passive Si plate with apertures. The plate shields the CMOS from high E-fields.

In an embodiment, an electrode arrangement such as a single electrode or a plurality of electrodes surrounds at least some of the apertures. In an arrangement a single electrode is assigned for example around each aperture. In another embodiment, a plurality of electrode elements are provided around each aperture for example as a detector element. The signal charged particles captured by the electrode elements surrounding one aperture may be combined into a single detection signal or used to generate independent detection signals. The electrode elements may be separated radially (i.e., to form a plurality of concentric annuluses), angularly (i.e., to form a plurality of sector-like pieces), both radially and angularly (providing an arrangement like a dart board), or in a grid (for example as a chess board) or in any other convenient manner.

In an arrangement a charged particle apparatus may comprise a plurality of charged particle devices as shown in and describe with reference to **FIG. 3** configured scan and image one or more samples simultaneously. Such a charged particle apparatus may comprise a multi-column system of the plurality of charged particle devices.

The charged particle device 41 of **FIG. 3** may comprise a first module 61 and a second module 62 configured to engage each other such that the first module is aligned relative to the second module 62, as described above with regard to **FIG. 2****.** In an arrangement there may be more than two modules. The different modules 61, 62 may comprise one or more sub-modules 611, 612, 613, 614. Apportionment of the sub-modules to the different modules may vary between designs. The apportionment depicted is intended to be an exemplary arrangement. (Since the assembly between the sub-modules and modules may be similar, reference to a module incorporates reference to a submodule through the rest of the description unless stated to the contrary.) For example, there may be a module 611 comprising the source, another module 612 comprising the array of condenser lenses 231, another module comprising the deflectors 235, and a downbeam module 614 comprising components downbeam of the deflectors 235. For example, the downbeam module may comprise one or more of the control lens array 250, array of scan deflectors 260, objective lens array 401 and/or detector module 402.

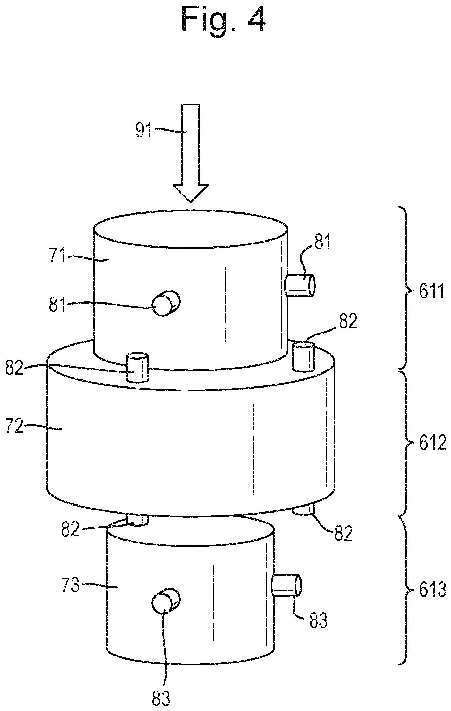

Apparatus, for example for measuring, inspecting, processing or fabricating a semiconductor component, may comprise a plurality of modules 611, 612, 613 (or 61, 62) configured to engage each other. Such a module may comprise a body and a plurality of engagers; a part of the charged particle device 41 such as the source 201. A first module 611 comprising a body 71 and a plurality of engagers 81 is illustrated in **FIG. 4****.** The first module 611 may be a module 611 comprising the source 201 such as of **FIG. 3****.** A second module 612 comprising a body 72 and a plurality of engagers 82 is illustrated in **FIG. 4****.** The second module 612 may be a module 612 comprising the array of condenser lenses 231 such as of **FIG. 3****.** A third module 613 comprising a body 73 and a plurality of engagers 83 is illustrated in **FIG. 4****.** The second module 613 may be a module 613 comprising a collimator such as deflectors 235 of **FIG. 3****.** Although the different modules are specifically described to have specific components, this described arrangement is exemplary and such a module may have two more of adjacent electron-optical components of a device such as the charged particle device 41 which may take the form of a column.

A modular assembly may be provided for engaging modules, such as the first module 611 and second module 612, and/or the second module 612 and third module 613, of the apparatus together. It may be desirable to engage the modules together such that the first module 611 is positioned at a predetermined target position relative to the second module 612, or vice versa. That is, it is desirable for the first and second modules 611, 612 to be engaged when the first module 611 and the second module 612 are at a determined position with respect to each other; such a relative position may be referred to the predetermined target position (Note reference herein to positioning of a feature with respect to a different feature, such as the first and second modules, may be considered to mean position the different feature with respect to the feature or relative positioning the feature and the different feature with respect to each other). For some applications, it may be desirable to position the first module 611 relative to the second module 612 to within a few microns, especially below tolerance of 5 microns or less, of the target position. It is therefore desirable for the modular assembly to provide means to aid in locating the modules at the target position and means for verifying that the modules are located at the target position. The engagers 81 of the first module 611 may be configured to engage or contact the engagers 82 of the second module 622 when the first module 611 is in the target position relative to the second module 612. In this way, the engagers 81, 82 of both modules may facilitate the alignment of the modules relative to each other by providing a contact points between the two or more modules.

The modular assembly of **FIG. 4** comprises three modules 611, 612, 613 configured to be mutually engageable to adjoin each other in a direction indicated by the arrow 91. (Note the reference numbers are by way of convenience and are not intended to refer to the precise same modules shown in and described with reference to **FIG. 3****,** although they may be used in such an arrangement. This part of the description is intended to refer to the manner of engagement of the different modules rather than then engagement of the specific different electron-optical components within them). In other words, the first module 611 and the third module 613 are desirably disposed at a target position relative to the second module 622 when the apparatus is in operation. When the first module 611 is in the target position, one or more surfaces of the first module 611 may be in contact with the second module 612. The engagers 82 of one module 612 are each configured to engage with a corresponding engager 81 of another of the module 611. In other words, the modules are configured such that when the first module 611 is in the target position relative to the second module 612, each of the engagers 81 of the first module 611 will contact an engager 82 of the second module 612.

The position of the engagers is desirably known to within a predetermined tolerance such that the relative positions of the modules, as determined by the engagers, can be verified to the required degree of precision. Desirably the predetermined tolerance is 5 microns or less. Such verification helps to ensure that the components, for example electron-optical components, within the different modules are aligned with sufficient accuracy to each other, for example with sufficient accuracy with respect to an intended charged particle beam path along which the components are positioned during operation. For example, the engagers of each module may be calibrated during manufacture so that their positions are within tolerance requirements. For example the different modules may be calibrated before assembly (i.e. pre-calibrated). In this way, the engagers of the two adjoining modules can be relied on to engage as expected when the modules are correctly aligned for operation. For example, the positions of the engagers are pre-calibrated with respect to the body of the respective module. Since the module may comprise a component (such as electron-optical component), the engagers may be pre-calibrated during manufacture of the module with respect to the component. Since the component may be required to be positioned within a certain range an intended path, e.g. an alignment path such as a charged particle beam path, the engagers may be positioned with respect to such an intended path within the module. The engagers may be pre-calibrated to be positioned with respect to a charged particle beam when the modules are assembled and the charged particle device is in operation.

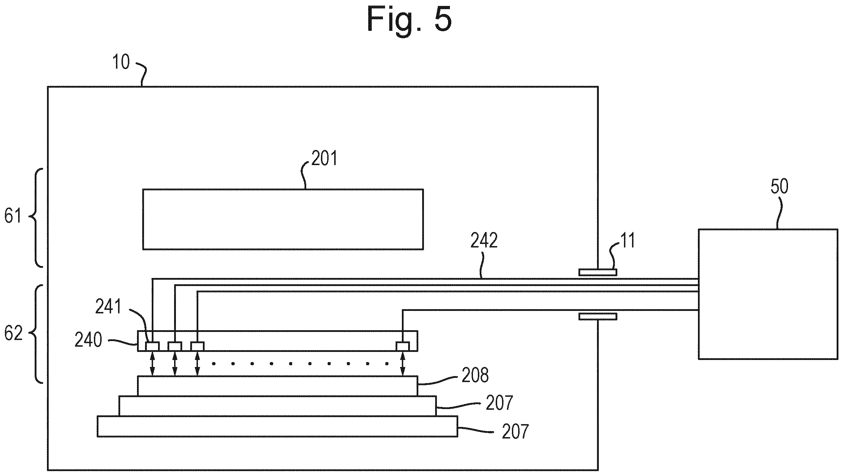

An arrangement involving multiple optical fibers (or other communication channels) is shown in **FIG. 5****.** Each optical fiber 242 is connected to a sub-unit (or detector unit) 241 of the detector module 240 and transmits signals generated by the respective sub-unit 241 to the data processing device 500 which is external to the main chamber 10. Each sub-unit 241 may include one or more individual electrodes of the detector module 240. It will be seen that in a multi-column system (or a multi charged particle device system or multi-device system) that is capable of imaging a large portion of the sample 208 at a time, there will need to be a large number of optical fibers 242 and hence vacuum feedthrough 11 must be large. As well as taking up space, a large vacuum feedthrough, or multiple smaller feedthroughs, can be difficult to seal.

It should be noted that a detector module, or detector array for an arrangement comprising a plurality of planar electron-optical elements, e.g. electrodes, placed along the multi-beam path, may have internal circuitry. The internal circuitry may comprise part or all of the processing circuitry, e.g. a CMOS structure, for connecting the individual detector elements, or detector units, in the detector array. In an alternative arrangement, two or more of the signal conduits for different detector units, may have a common or adjacent connection in the surface of the detector module. Co-locating a plurality of connections for signal conduits to the detector module simplifies connection of the signal conduits and the detector module to each other. In an arrangement multiple detector units have a common signal conduit, so multiple detector units may be grouped. Each detector unit may be associated with a beam of a multi-beam, such that a detector is arranged to detect signal particles from the sample generated by a specific beam of the plurality of beams. In a different arrangement an array of detector units each associated with a different pixel may be associated with a beam of the plurality of beams. Such an arrangement may be suited to an inspection system for finding detects. Such an arrangement may be suited to a metrology system where each pixel, e.g. a detector unit, is for counting signal electrons.

The arrangement of **FIG. 5** may comprise a plurality of modules configured to engage each other. For example, as shown in **FIG. 2****,** one module 61 may comprise the source 201, for example at least the source and optionally one more or other parts of the charged particle device 41. Another module 62 may comprise other parts of the charged particle device, such as the charged particle detection components, such as the detector 240 and sub-units 241. These modules may be configured to engage each other such that the module 61 is aligned with respect to the other module 62. The modules 61, 62 may be configured to align relative to the beam of charged particles 202.

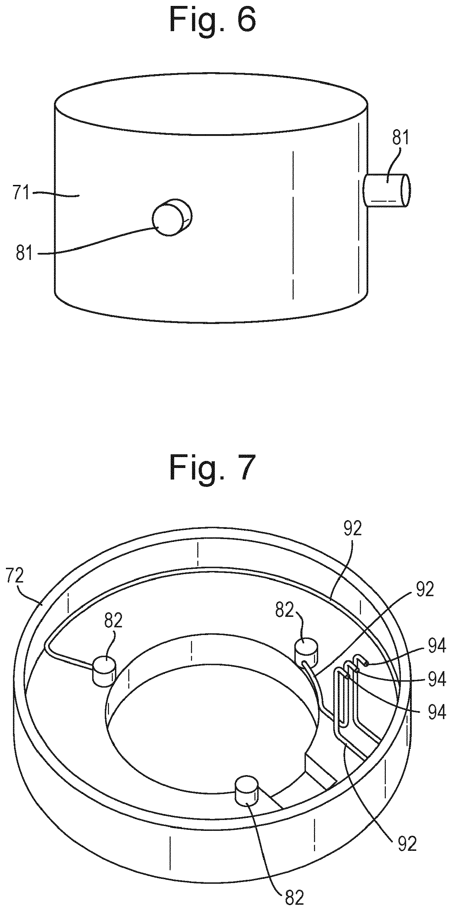

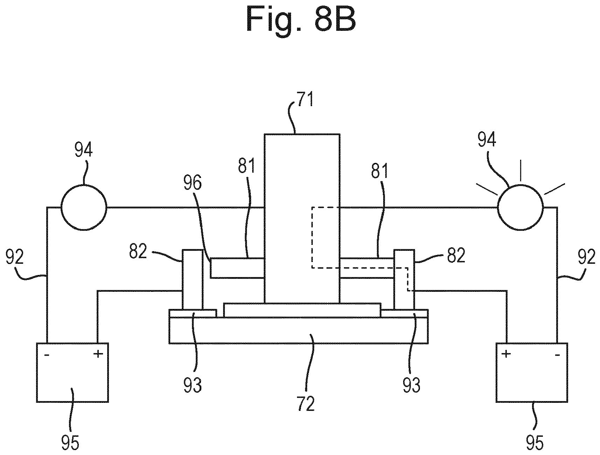

A first module 611 comprising a body 71 and a plurality of engagers 81 is illustrated in **FIG. 6**. A second module 612 comprises a body 72 and a plurality of engagers 82 is illustrated in **FIG. 7****.** The first and second modules may each include one or more parts of the charged particle device 41 of **FIG. 3****.** For example, the first module 611 may include the source 201 and the second module 612 may include the array of condenser lenses 231. The first module 611 is configured to engage the second module 612 such that the first module is aligned, in a target position, relative to the second module 612 when all of the engagers 81 of the first module 611 are engaged with engagers 82 of the second module 612. As shown in **FIG. 7**, each of the engagers 82 of the second module 612 is connected to a verification circuit 92, or at least the electrical routing such wires and other conductors of such a circuit. That is a different verification circuit 92 may comprise a different engager 82 of the second module 612. The body of the first module 611 may be connected to an electrical supply of the same verification circuits (see electrical supply 95 of **FIG. 8B**)**.** That is the same body 71 of the first module 611 may be connected to all the different verification circuits. The body 71 and engagers 81 of first module 611 may be in electrical communication with each other, for example the body 71 and engagers 81 of first module 611 may be in direct electrical contact with each other. Connection of an electrical supply of one of the verifications circuits to the body 71 of the first module 611 is in effect electrical connection of the engagers 81 of the first module 611.

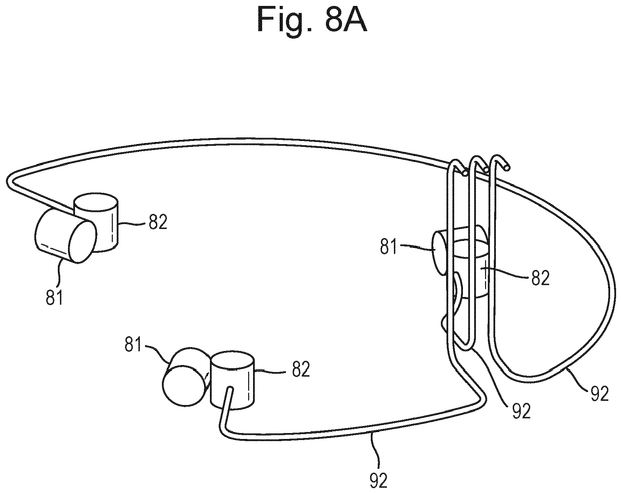

**FIG. 8A** shows elements of a modular assembly comprising the first module 611 and the second module 612. **FIG. 8A** illustrates an arrangement wherein the module 611 is in the target position relative to the second module 612. The first and second module 611, 612 are depicted when they are engaged. The module bodies 71, 72 are not shown to enable clearer view of the engagers and verification circuits. In this position, each of the engagers 82 of one module (e.g. the second module 612) is engaging a corresponding engager 81 of the other module (e.g. the first module 611). Each of the engagers 82 of one of the modules (e.g., the second module 612) is in contact with a corresponding engager 81 of the other module (e.g. the first module 611). Each verification circuit 92 is configured to be closed, or completed, on engagement of an engager 81 of one of the modules (e.g. the first module 611) with a corresponding engager 82 of the other of the modules (e.g. the second module 612). In this way the modular assembly may be used to verify that each engager 82 of one module 612 has engaged its corresponding engager 81 of the other module 611. This is because the engagers of the different modules that become engaged are in electrical communication (and so part of) the same verification circuit.

In the arrangement shown in **FIG. 8A**, the engagers 82 of the second module 612 are configured to be electrically isolated from the body 72 of the second module 612. In the arrangement the corresponding engagers 81 of the first module 611 are configured to be electrically connected to the body 71 of the first module 611. Thus there is isolation, such as an isolator 93, between the body 72 of the second module 612 and the engagers 82 of the second module. Such an arrangement is shown schematically in **FIG.8B** in which the same features have the same reference numbers as in **FIGs 6, 7** **and** **8A****.** In the depicted arrangement two verification circuits 92 are shown with an isolator 93 between the body 72 of the second module and the engagers 82 of the second module 612. The verification circuits 92 are shown connected to the body 71 of the first module 611 and to a respective electrical supply 95. In this way, each verification circuit 92 is not completed until an electrical connection is made to the verification circuit 92 by an engager 82 of the second module 612 making a physical and electrical connection with a corresponding engager 81 of the first module 611. If a verification circuit 92 is complete, or closed, then an engager 81 of the first module 611 and a corresponding engager 82 of the second module 612 are in contact. If all of the verification circuits 92 are complete, or closed, then each engager 81 and corresponding engager 82 must be in contact. This is depicted in **FIG 8B****.** In one verification circuit (to the left) a gap 96 is shown between engagers which can be detected by an alarm 94. In the other verification circuit 92 (to the right) the engagers 81, 82 contact each other (are engaged) which can be detected by the alarm 94. Details of the alarm are referred to later herein. Different arrangements for the isolation may be used for example: an isolation layer may be between the engager and the body 72 of the second module; or the engager comprise an isolation material (i.e. other than in the electrical path between the connection to the verification circuit and the point of contact for contact with another engager of a different module); or another practical arrangement which is apparent to a person skilled in the art.

Each engager of one module and corresponding engager of another module may be referred to as a pair of engagers which engage to complete a verification circuit. In each pair of engagers there is an isolated engager of a module and a connected engager of another module. In each pair of engagers, the isolated engager is configured to be electrically isolated from the body of the first module and the connected engager is configured to be electrically connected to the body of second module. The isolated engager of the engager pair is connected to the verification circuit so that contact between the isolated engager and the connected engager of the engager pair completes the verification circuit. **FIG. 7** and **FIG. 8A** illustrate an arrangement wherein all of the verification circuits 92 are provided on the same module 612. This means that, in the arrangement of FIG. 6, **FIG. 7** and **FIG. 8**, the isolated engagers are the engagers 82 of the second module 612 and the connected engagers are the engagers 81 of the first module 611. In other words, the body 72 and multiple engagers 81 of the one of the modules 612 are configured to be electrically isolated from each other, and the body 71 and the multiple engagers 81 of the other of the modules 611 are configured to be electrically connected to each other.

In an alternative arrangement, not all of the verification circuits may be provided on the same module. A module may comprise a plurality of engagers, each belonging to a respective pair of engagers. The plurality of engagers may include one or more first engagers, each electrically isolated from the body of the module and each connected to a verification circuit, and one or more second engagers, electrically connected to the body of the module. An example module with such engagers is the second module shown in and described with reference to **FIG. 4****.**

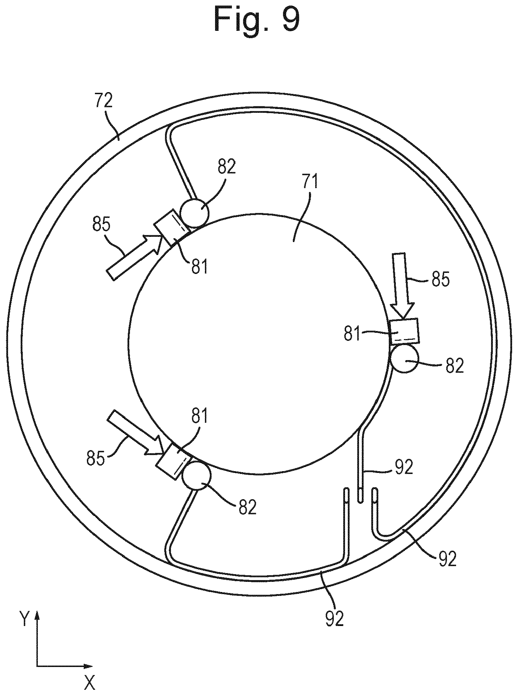

**FIG. 9** illustrates a plan view of the modular assembly of **FIG. 8A****.** Unlike in **FIG. 8A****,** the body 71 of the first module 611 and the body 72 of the second module 612 are visible in **FIG. 9.** FIG. 9 additionally includes arrows 85 indicating a direction of a load applied to force each engager 82 and corresponding engager 81 together. The components depicted in **FIG. 9** are otherwise the same as those shown in **FIG. 8** and described above with reference to **FIG. 8****.**

The modular assembly desirably further comprises a pre-tension unit (not depicted) configured to apply the load to force the engager 82 and the corresponding engager 81 together. The modular assembly may comprise a plurality of pre-tension units, each configured to apply the load to force one of the engagers 82 and corresponding engagers 81 together, as shown in **FIG. 9****;** for example when engaging the pair of engagers 81, 82 together. Furthermore, as shown in **FIG. 9****,** each pre-tension unit is desirably configured to apply the load in a single translational direction. Each engager 82 is configured to engage with the corresponding engager 82 at a contact point on an interface surface of the corresponding engager. The pre-tension unit is configured to apply the load (referred to as a pre-tension load) in a direction normal to the interface surface of the corresponding engager at the contact point. The pre-tension unit may be arranged to apply force to the engager (with which it is associated) in opposition to the force applied to the engager at the contact point (i.e. between the engager and the corresponding engager). The pre-tension unit may be of same module as the engager with which it is associated or external to the module of the engager to which it is associated.

The pre-tension unit may, for example, comprise a resilient member such as a spring element. On contact between two engagers of different modules, the resilient member may be between the bodies of the different modules during engagement of the modules. The pre-tension unit may help to ensure that the engagers remain in contact with each other, provided the modules are aligned to each other within a few microns of the desired relative alignment between the modules.

The load applied by the pre-tension unit is desirably higher than a distortion load, desirably to create the load as a pre-tension on the corresponding engager, for example the interface surface between engaging engagers of the two modules. The distortion load is a threshold load above which one or both of the modules or a component thereof may be permanently distorted, for example may be subject to plastic deformation. That is the pre-tension is limited. The limitation to the magnitude of the pre-tension load is that it should not exceed the maximum allowable load on the engagers, where the maximum allowable load is a load corresponding to a maximum allowable deformation of the engagers for the alignment to be within an acceptable tolerance.

The pre-tension load is optionally set by iteratively applying a load until it is determined that the pre-tension load is greater than the distortion force. In other words, the pre-tension load may be increased in iterations until the verification circuit shows that the engagers are consistently in contact. This iteration may be carried out when installing or replacing the module. Desirably, the pre-tension load is as high as possible without significantly exceeding the distortion load. For example, the pre-tension load may be between 50 N and 150 N, desirably between 70 N and 120 N, more desirably between 80 N and 110 N. The distortion load may be between 800 N and 150 N.

There is optionally a sealing member which may be made of a resilient material which may be annular, e.g. an O-ring, between the two modules. The modules will be pressed together with the sealing member between the module for example for forming a seal between the modules. For example the modules will be pressed together in a Z-direction, with the sealing member (e.g. O-ring) being between the two modules in the Z-direction. A plurality of engagers may be distributed at the required locations and orientations to verify whether the two modules are relatively aligned in an X-direction, a Y-direction and a rotational direction around the Z-direction.

The pre-tension unit is configured to apply a load to the pair of engagers such that the engagers are forced together. For example, the force may cause the engager to deflect by a deflection distance. Due to the deflection, each engager and corresponding engager may remain engaged, in contact with each other, even if the relative position of the modules changes by a few microns. In this way, the engagement of each pair of engagers can be used to verify that the relative position of the modules is within the deflection distance of the target position in the direction of engagement of the pair of engagers. The deflection distance may be up to 20 microns, preferably up to 10 microns, more preferably up to 5 microns. Desirably the deflection should be below the size of the tolerance. Engagement of the engagers and corresponding engagers is desirably used to verify alignment of the modules relative to each other. If there is no deflection of the engagers, the engagement may be lost by even a very small misalignment, for example of 1 micron. Whereas, in practical applications, a misalignment within the deflection distance may be acceptable and expected. As such, the application of the pre-tension load may prevent the verification circuit from becoming incomplete/open and triggering a re-alignment of the modules when the modules are actually aligned within acceptable tolerance for the application. As such, this arrangement may save a significant amount of time, for example days of time during which it would otherwise not be known that there was a misalignment, or which module was misaligned in which degree of freedom. It may also avoid unnecessary re-alignment of modules.

The modular assembly may comprise up to six engagers for example for engaging between two modules. Desirably, the engagers of one module are configured to engage with the corresponding engagers of the other module such that the two modules are aligned in up to six degrees of freedom.

For example, the modular assembly of **FIG. 9** comprises six engagers. In other words, each of the two modules 611, 612 of the arrangement of **FIG. 9** comprises three engagers 81, 82. The number of pairs of engagers that engage two modules may correspond to the number of degrees of freedom which may be aligned in the modular assembly.

The three engagers of each module are arranged such that when the three engager of one module are engaged with the three corresponding engagers of the other module. Thus with engagement of three pairs of engagers a modular assembly may be aligned in three degrees of freedom. Desirably, the two modules are aligned in two translational degrees of freedom and one rotational degree of freedom. For example, the two modules of **FIG. 9** are arranged such that the modules are aligned in the translational horizontal, or X-Y directions, and a are aligned in a rotational direction about the vertical, or Z-direction.

In the arrangement of **FIG. 9****,** the body 71 of the first module 611 is partially within the body 72 of the second module 612 when the modules are engaged. The modules are concentric with respect to each other and share a common axis. The common axis is an axis in the Z-direction, orthogonal to the X-Y directions of **FIG. 9****.** Desirably, the common axis is of an alignment path such as a beam path of radiation such charged particles or light during operation of an apparatus comprising the modular assembly.

Each verification circuit may be configured to verify the alignment of the positioning of the two modules with respect to each other in one degree of freedom on closure of the verification circuit. In other words, each verification circuit may be complete, or closed, when the first module 611 and the second module 612 are aligned in a single degree of freedom. Thus the number of verification circuits closed may indicate the number of pairs of engagers in contact and the number of degrees of freedom in which the engaged modules are aligned with respect to each other. The degree of freedom desirably corresponds to the direction of the load applied by the pre-tension unit.

The modular assembly is desirably configured so that alignment between two modules is verified on closure of the verification circuits of all of the multiple engagers of the two modules.

The modular assembly may comprise, or be configured to control, an alarm 94 such as loud speaker or a light. An alarm 94 such as a light (which lights on closure of a corresponding verification circuit 92) is depicted in each of **FIGs 7****,** **8** **and** **9****.** The modular assembly is desirably configured to trigger the alarm on closure of all of the verification circuits. Desirably there are a plurality of alarms each corresponding to a different verification circuit, and the modular assembly is configured to trigger each of the alarm when the verification circuit corresponding to the alarm is completed, or closed.

The modular assembly may be configured such that, when alignment between two modules is verified, the module is configured to be aligned with a beam path of particles, which may be photons or charged particles, common to the modules of the modular assembly.

**FIG. 9** provides an example of a modular assembly comprising two modules 611, 612. However, as shown for example in **FIG. 4****,** an apparatus may comprise more than two modules, for example three modules 611, 612, 613. As shown for example in the arrangement of **FIG. 4****,** in addition to the first module 611 and the second module 612, the modular assembly may comprise at least a further module 613 comprising at least one engager 83 configured to engage with an engager 82 of one of the two modules 611, 612. The further module 613 comprises a further body 73 and further multiple engagers 83 that are each configured to engage with a corresponding engager 82 of another of the modules (e.g. the second module 612). Engagement of each the engagers 83 of the further module 613 with corresponding engagers 82 of the other module (e.g. the second module 612) may complete a corresponding verification circuit, similar to the above described verification circuits of the arrangement of **FIG. 8****.** The features may be the same unless stated to the contrary. The completion of all of the verification circuits associated with the engagers 83 of the further module 613 may verify that the further module 613 is aligned relative to the other module (e.g. the second module 612).

The modular assembly may comprise more than three modules. Furthermore, a module may be provided with engagers configured to engage with engagers of more than one other module. In other words, a first module may be provided with two engagers where one of the two engagers is configured to engage a corresponding engager of a second module to complete a first verification circuit (or a set of verification circuits if multiple pairs of engagers are for engaging between the first and second modules) and the other of the two engagers is configured to engage a corresponding engager of a third module to complete a second verification circuit (or a set of second verification circuits if multiple pairs of engagers are for engaging between the first and third modules). In this way it may be verified that the first module is aligned, or positioned, correctly relative to the other two modules in at least one degree of freedom.

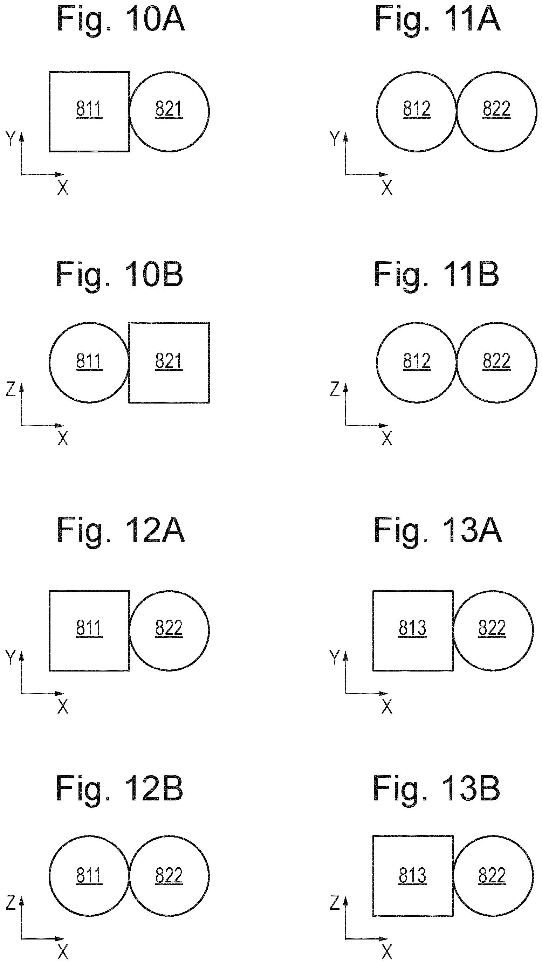

The engager of one of the modules is desirably configured to engage with the corresponding engager of the other module at a single point of contact therebetween. The engager may have an interface surface configured to contact an interface surface of the corresponding engager. The interface surfaces of the engagers may be shaped such that there is a single point of contact between the engager and the corresponding engager. In other words, it is desirable that each pair of engagers (comprising an engager of one module and a corresponding engager of another module) dictate the relative position of the two modules in only one degree of freedom. This may be achieved, for example, by using engager pairs shaped as described below with reference to **FIG. 10 to 13****.**

**FIG. 10A** shows an engager 811 and a corresponding engager 821 from above, in a plan view. **FIG. 10B** shows the engager 811 and corresponding engager 821 of **FIG. 10A** from a side view orthogonal to the plan view. Similarly to the arrangements of **FIGs. 4****,** **8** **and** **9****,** in the arrangement of **FIG. 10A and 10B** the engager 811 has a cylindrical surface configured to contact a cylindrical surface of the corresponding engager 821.

The single point of contact can be a point of contact between two cylinders which are angled relative to each other, as shown in **FIG. 10A and 10B**. Alternatively, one or both of the engager and the corresponding engager may have an interface surface which is only part of a surface of a cylinder, such as a semi-cylinder. The engager and the corresponding engager may each have a convex surface, which is not necessarily a cylindrical surface, as an interface surface. Desirably the interface surface of the engager is curved in a first direction and configured to engage a convex surface desirably which is curved in a second direction. Desirably the second direction is angled relative to the first direction. Desirably, the second direction is orthogonal to the first direction. In this way a single point of contact may be achieved between the engager and the corresponding engager.

**FIG. 11A** shows an engager 812 and a corresponding engager 822 from above, in a plan view. **FIG. 11B** shows the engager 812 and corresponding engager 822 of **FIG. 11A** from a side view orthogonal to the plan view. In the arrangement of **FIG. 11A and 11B** the engager 812 has a spherical surface configured to contact a spherical surface of the corresponding engager 822.

The single point of contact can be a point of contact between two spheres, as shown in **FIG. 11A and 11B****.** Alternatively, the engager and the corresponding engager may each have a convex surface which is curved in two directions, which is optionally at least part of a spherical surface, as an interface surface.

**FIG. 12A** shows an engager 811 and a corresponding engager 822 from above, in a plan view. **FIG. 12B** shows the engager 811 and corresponding engager 822 of **FIG. 12A** from a side view orthogonal to the plan view. In the arrangement of **FIG. 12A and 12B** the engager 811 has a cylindrical surface configured to contact a spherical surface of the corresponding engager 822.

The single point of contact can be a point of contact between a cylinder and a sphere as shown in **FIG. 12A and 12B****.** Alternatively, the engager may have an interface surface which is only part of a surface of a cylinder, such as a semi-cylinder. The engager may each have a convex surface, which is not necessarily a cylindrical surface, as an interface surface. Desirably the interface surface of the engager is curved in a first direction. The corresponding engager may have a convex surface which is curved in two directions as an interface surface. In an alternative arrangement the engager may have a convex surface which is curved in two directions, for example at least part of a spherical surface, as an interface surface, and the corresponding engager may have a convex surface, for example a cylindrical surface, as an interface surface.

**FIG. 13A** shows an engager 813 and a corresponding engager 822 from above, in a plan view. **FIG. 13B** shows the engager 813 and corresponding engager 822 of **FIG. 13A** from a side view orthogonal to the plan view. In the arrangement of FIG. 13A and 13B the engager 813 has a planar surface, such as a flat surface, configured to contact a spherical surface of the corresponding engager 822.

The single point of contact can be a point of contact between a planar surface and a sphere as shown in **FIG. 13A and 13B****.** Alternatively, the engager may have a planar surface as the interface surface and the corresponding engager may have convex surface which is curved in two directions, for example a semi-sphere, as an interface surface.

In any of the above example configurations of engager and corresponding engager, the shape of the interface surface of the engager and the shape of the interface surface of the corresponding engager may be swapped. For example, although **FIG. 13A and 13B** shows the engager having a planar surface as the interface surface and the corresponding engager has a spherical surface as an interface surface, an alternative arrangement may be provided wherein the engager has a spherical surface as its interface surface and the corresponding engager has a planar surface as its interface surface.

In some arrangements, such as those of **FIG. 4** **and** **FIGs. 7 to 10****,** each module comprises a plurality of engagers. In the arrangements of **FIG. 4** **and** **FIGs. 7 to 10**, all of the engagers have the same shape of interface surface, in particular a cylindrical interface surface. In alternative arrangements, a module may comprise two or more engagers and the two or more engagers may have different shaped interface surfaces. For example, a module may comprise a first engager having a spherical interface surface and a second engager having a planar interface surface.

At least one of the modules of the modular assembly may comprise a complex element, for example an optical or electron-optical element or another system for use in fabricating a semiconductor component or a different component requiring patterning. Desirably, such an optical or electron-optical element may comprise at least one of a lens, a beam limiting aperture, a corrector, a detector, and source. More desirably wherein one or more of the elements comprise arrays. More than one of the modules of the modular assembly may comprise a complex element. At least two adjoining modules comprise complex elements which are configured to electron-optically or optically interact with other during operation of the apparatus. For example, all of the modules of the modular assembly may comprise complex elements. The modules are desirably configured to align relative to a beam path of particles, for example of photons or charged particles such as electrons. The verification circuits may be used to establish that the adjoining modules are mechanically aligned. Components directing the beam of charged particles, such as the objective lens array may be aligned to mechanical components of the module.

The body of one or more of the modules comprises at least part of a vacuum chamber wall. The body of one or more of the different modules may provide the walls of the vacuum chamber. Adjacent modules may comprises elements that form a pressure resistant seal between the bodies of the two adjacent modules on engagement of the adjacent modules. Therefore there may be a seal provided between one module and an adjacent other module such that the interface, or engaging surface(s) of the modular assembly are configured to be sealed. In an embodiment, the module may be parts, for example sections, of an electromagnetic shield for example for magnetic shielding comprising mu metal.

Although the invention has been described with reference to an assessment system for example a charged particle assessment system, the invention may be applied to any other suitable system Such modules and a modular assembly comprising at least two adjacent modules may comprise part of an optical or electron optical system or another other system for fabricating a patterned product such as a semiconducting component such as a chip. Such systems may comprise at least one of a lithographic system such as an electron or photon lithographic systems, an assessment system such as a metrology or inspection system or a system for use in track such as a coater, developer or other processing system.

There is provided the following clauses:
Clause 1. A modular assembly for engaging modules of an apparatus together, the apparatus for measuring, inspecting, processing or fabricating a semiconductor component, the assembly comprising: two modules configured to be mutually engageable to adjoin each other, the modules each having a body and multiple engagers that are each configured to engage with a corresponding engager of another of the modules and to complete a corresponding verification circuit; wherein each verification circuit is configured to be closed on engagement of an engager of one of the modules with a corresponding engager of the other of the modules, wherein the engager is configured to be electrically isolated from the body of the one of the two modules, and the corresponding engager is configured to be electrically connected to the body of the other of the two modules.
Clause 2. The modular assembly of clause 1, wherein the body and multiple engagers of the one of the modules are configured to be electrically isolated from each other, and the body and the multiple engagers of the other of the modules are configured to be electrically connected to each other.
Clause 3. The modular assembly of either of clauses 1 and 2, wherein the engager is configured to engage with the corresponding engager at a single point of contact therebetween.
Clause 4. The modular assembly of any of clauses 1 to 3, further comprising a pre-tension unit configured to apply a load to force the engager and the corresponding engager together.
Clause 5. The modular assembly of clause 4, wherein the pre-tension unit is configured to apply the load in a single translational direction.
Clause 6. The modular assembly of either of clauses 4 and 5, wherein the pre-tension unit comprises a spring element.
Clause 7. The modular assembly of any of clauses 4 to 6, wherein the load is between 50 N and 150 N.
Clause 8. The modular assembly of any of clauses 4 to 7, wherein the load is higher than a distortion load, desirably to create the load as a pre-tension on the corresponding engager.
Clause 9. The modular assembly of any of clauses 3 to 8, wherein the engager is configured to engage with the corresponding engager at a contact point on a surface of the corresponding engager.
Clause 10. The modular assembly of clause 8 or 9, wherein the pre-tension unit is configured to apply the load in a direction normal to the surface of the corresponding engager at the contact point.
Clause 11. The modular assembly of any preceding clause, wherein each module comprises up to six engagers and desirably wherein the engagers of one module are configured to engage with the corresponding engagers of the other module such that the two modules are aligned in up to six degrees of freedom.
Clause 12. The modular assembly of clause 11, wherein the two modules each comprise three engagers.
Clause 13. The modular assembly of clause 12, wherein the three engagers of each module are arranged such that when the three engager of one module are engaged with the three corresponding engagers of the other module, desirably the two modules are aligned in two translational degrees of freedom and one rotational degree of freedom.
Clause 14. The modular assembly of any preceding clause, wherein each verification circuit is configured to verify the alignment of the positioning of the two modules with respect to each other in a degree of freedom , desirably the degree of freedom being a direction on closure of the verification circuit.
Clause 15. The modular assembly of any preceding clause, wherein the modular assembly is configured so that alignment between two modules is verified on closure of the verification circuits of all of the multiple engagers of the two modules
Clause 16. The modular assembly of clause 15, wherein, when alignment between two modules is verified, the module is configured to be aligned with a beam path of particles common to the modules of the modular assembly.
Clause 17. The modular assembly apparatus of any preceding clause, further comprising an alarm such as loud speaker or a light configured to be triggered on closure of each verification circuit.
Clause 18. The modular assembly of any of clauses 3 to 17, wherein one of the engager and the corresponding engager has a convex surface desirably which is curved in a first direction, desirably the convex surface is at least part of a surface of a cylinder, configured to engage a convex surface desirably which is curved in a second direction, angled desirably orthogonal to the first direction, desirably the convex surface is at last part of a surface of a cylinder, of the other of the engager and the corresponding engager.
Clause 19. The modular assembly of any of clauses 3 to 17, wherein one of the engager and the corresponding engager has a convex surface, desirably which is curved in one direction, desirably the engager has cylindrical shape comprising the convex surface, desirably the convex surface is configured to engage a convex surface of the other of the engager and the corresponding engager which is curved in two directions, desirably the convex surface of the other of the engager and the corresponding engager is a spherical surface.
Clause 20. The modular assembly of any of clauses 3 to 17, wherein one of the engager and the corresponding engager has convex surface which is curved in two directions, desirably a spherical surface, desirably a surface of the other of the engager and the corresponding engager has a planar surface, desirably the convex surface is configured to engage the planar surface of the other of the engager and the corresponding engager.
Clause 21. The modular assembly of any of clauses 3 to 17, wherein the engager and the corresponding engager each have a convex surface which is curved in two directions, desirably a spherical surface, desirably the convex surface of the engager and the convex surface of the corresponding engager are configured to engage each other.
Clause 22. The modular assembly of any preceding clause, wherein the body of one of the modules is within the body of the other of modules when the modules are engaged, desirably so that modules are concentric with respect to each other and a common axis, desirably the common axis is of a beam path of radiation such charged particles or light during operation of an apparatus comprising the modular assembly.
Clause 23. The modular assembly of any preceding clause, wherein at least one of the modules comprises a complex element, for example an optical or electron-optical element, desirably at least one of a lens, a beam limiting aperture, a corrector, a detector, and source, desirably wherein one or more of the elements comprise arrays.
Clause 24. The modular assembly of any preceding clause, wherein at least two adjoining modules comprise complex elements which are configured to electron-optically or optically interact with other during operation of the apparatus.
Clause 25. The modular assembly of any preceding clause, wherein the modules are configured to align relative to a beam path of particles, for example of photons or charged particles.
Clause 26. The modular assembly of any preceding clause, wherein the body of one or more of the modules comprises at least part of a vacuum chamber wall.
Clause 27. The modular assembly of any preceding clause, further comprising at least a further module comprising at least one engager configured to engage with an engager of one of the two modules, desirably the further module comprising a further body and further multiple engagers that are each configured to engage with a corresponding engager of another of the modules and to complete a corresponding verification circuit for verifying alignment of the further module with one of the two other modules.
Clause 28. A modular assembly for verifiably engaging modules together of an apparatus for measuring, inspecting, processing or fabricating a semiconductor component, the modular assembly comprising: two modules that adjoin each other and are mutually engageable, the modules having a body and multiple engagers, the individual engagers engaging with a corresponding engager of the adjoining module to close a respective individual verification circuit for verifying alignment in a degree of freedom.
Clause 29. The assembly of clause 28, wherein the individual engagers of a first module engage with a corresponding engager of a second module at a single point of contact under a limited pre-tension.
Clause 30. The assembly of clause 28, wherein the individual engagers engage with a corresponding engager of the adjoining module at a single point of contact.
Clause 31. The assembly of 28 or 29, wherein the individual engagers of one of the first or second module are isolated from the body of that module.
Clause 32. The assembly of any of clauses 28 to 31, wherein at least one the individual engagers of a first one of the two modules is electrically isolated from the body of the first module, and the corresponding engager of the second of the two modules is electrically connected to the body of the second module.
Clause 33. The assembly of any of clauses 28 to 32, wherein at least one of the modules comprises an isolator between the body and each of the engagers of the module.
Clause 34. The assembly of any of clauses 28 to 33, further comprising a pre-tension unit to apply a load to force an individual engager and the corresponding engager of the other body together.
Clause 35. The assessment apparatus of clause 34 wherein the pre-tension unit is configured to apply the load in a single translational direction.
Clause 36. The assessment apparatus of clause 34 or 35, wherein the pre-tension unit comprises a resilient member such as a spring.
Clause 37. The assessment apparatus of clause 36, wherein the resilient member is a resilient member between the bodies during engagement of the bodies.
Clause 38. The assessment apparatus of any of clauses 34 to 37, wherein the load is higher than a threshold load (or distortion load) so the load is as a pre-tension applied on the corresponding engager.
Clause 39. The assembly of any of clauses 28 to 38, wherein each module is pre-calibrated.
Clause 40. The assembly of clause 39, wherein the positions of the engagers with respect to the body of each module are pre-calibrated.
Clause 41. The assembly of clause 39 or 40, wherein the positions of the engagers are pre-calibrated with respect to a component (such as electron-optical component) comprised in the module, for example the engagers are pre-calibrated with respect to an alignment path such as an optical path, e.g. charged particle beam path within the module.
Clause 42. A modular assembly for verifiably engaging modules together of an apparatus for measuring, inspecting, processing or fabricating a semiconductor component, the modular assembly comprising: two modules that adjoin each other and are mutually engageable, the modules having a body and multiple engagers, the individual engagers engaging with a corresponding engager of the adjoining module to close a respective verification circuit, wherein the individual engagers of a first module engage with a corresponding engager of the second module at a single point of contact under a limited pre-tension, the individual engagers of one of the first or second module being isolated from the body of that module.
Clause 43. A device for projecting a beam of radiation such as photons or charged particles towards a sample, the device comprising the modular assembly of any proceeding clause.
Clause 44. An apparatus for measuring, inspecting, processing or fabricating a semiconductor component comprising the device of clause 43 or the modular assembly of any of clauses 1 to 27.
Clause 45. The apparatus of clause 44 further comprising a sample support configured to support a sample desirably a sample is a substrate, workpiece, or target.
Clause 46. The apparatus of clause 44 or 45, wherein the apparatus is a measurement system, an inspection system or a fabrication system.
Clause 47. The apparatus of any of clauses 44 to 46, wherein the apparatus is an optical apparatus for projecting light towards a sample such as an optical lithographic apparatus or an optical assessment apparatus; or an electron-optical apparatus for projecting charged particles towards a sample such as an electron-optical lithographic or assessment apparatus.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250 and the objective lens array 241.

References to upper and lower, up and down, above and below, etc. should be understood as referring to directions parallel to the (typically but not always vertical) up-beam and down-beam directions of charged particle beams impinging on the sample 208. Thus, references to up beam and down beam are intended to refer to directions in respect of the beam path independently of any present gravitational field.

Electron-optics described herein may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electromagnetic field of the compound lens array.

An assessment apparatus, tool or system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment apparatus, tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses disclosed herein.

## Claims

1. A modular assembly for engaging modules of an apparatus together, the apparatus for measuring, inspecting, processing or fabricating a semiconductor component, the assembly comprising:
two modules configured to be mutually engageable to adjoin each other, the modules each having a body and multiple engagers that are each configured to engage with a corresponding engager of another of the modules and to complete a corresponding verification circuit;
wherein each verification circuit is configured to be closed on engagement of an engager of one of the modules with a corresponding engager of the other of the modules, wherein the engager is configured to be electrically isolated from the body of the one of the two modules, and the corresponding engager is configured to be electrically connected to the body of the other of the two modules.

2. The modular assembly of claim 1, wherein the body and multiple engagers of the one of the modules are configured to be electrically isolated from each other, and the body and the multiple engagers of the other of the modules are configured to be electrically connected to each other.

3. The modular assembly of either of claims 1 and 2, wherein the engager is configured to engage with the corresponding engager at a single point of contact therebetween.

4. The modular assembly of any of claims 1 to 3, further comprising a pre-tension unit configured to apply a load to force the engager and the corresponding engager together.

5. The modular assembly of claim 4, wherein the pre-tension unit is configured to apply the load in a single translational direction.

6. The modular assembly of claim 4 or 5, wherein the load is higher than a distortion load, desirably to create the load as a pre-tension on the corresponding engager.

7. The modular assembly of any of claims 3 to 6, wherein the engager is configured to engage with the corresponding engager at a contact point on a surface of the corresponding engager.

8. The modular assembly of claim 6 or 7, wherein the pre-tension unit is configured to apply the load in a direction normal to the surface of the corresponding engager at the contact point.

9. The modular assembly of any preceding claim, wherein each module comprises up to six engagers and desirably wherein the engagers of one module are configured to engage with the corresponding engagers of the other module such that the two modules are aligned in up to six degrees of freedom.

10. The modular assembly of any preceding claim, wherein each verification circuit is configured to verify the alignment of the positioning of the two modules with respect to each other in a degree of freedom , desirably the degree of freedom being a direction on closure of the verification circuit.

11. The modular assembly of any preceding claim, wherein the modular assembly is configured so that alignment between two modules is verified on closure of the verification circuits of all of the multiple engagers of the two modules

12. The modular assembly of claim 11, wherein, when alignment between two modules is verified, the module is configured to be aligned with a beam path of particles common to the modules of the modular assembly.

13. The modular assembly of any preceding claim, wherein the body of one of the modules is within the body of the other of modules when the modules are engaged, desirably so that modules are concentric with respect to each other and a common axis, desirably the common axis is of a beam path of radiation such charged particles or light during operation of an apparatus comprising the modular assembly.

14. The modular assembly of any preceding claim, wherein at least two adjoining modules comprise complex elements which are configured to electron-optically or optically interact with other during operation of the apparatus.

15. The modular assembly of any preceding claim, wherein the modules are configured to align relative to a beam path of particles, for example of photons or charged particles.
